(19) Europäisches Patentamt
European Patent Office
Office européen des brevets

(11) Veröffentlichungsnummer: **0 032 373**
**B1**

# (12) EUROPÄISCHE PATENTSCHRIFT

(45) Veröffentlichungstag der Patentschrift: **06.10.82**

(21) Anmeldenummer: **81100030.6**

(22) Anmeldetag: **07.01.81**

(51) Int. Cl.³: **C 09 K 11/06,** C 07 D 239/70, C 09 B 5/16 // H01S3/20, H01L31/04

## (54) Lichtsammelsysteme und die Verwendung von Anthrapyrimidinderivaten als Energiewandler in ihnen.

(30) Priorität: **15.01.80 DE 3001149**

(43) Veröffentlichungstag der Anmeldung: **22.07.81 Patentblatt 81/29**

(45) Bekanntmachung des Hinweises auf die Patenterteilung: **06.10.82 Patentblatt 82/40**

(84) Benannte Vertragsstaaten: **CH DE FR GB IT LI**

(56) Entgegenhaltungen: **keine**

(73) Patentinhaber: **BAYER AG, Zentralbereich Patente, Marken und Lizenzen, D-5090 Leverkusen 1, Bayerwerk (DE)**

(72) Erfinder: **Claussen, Uwe, Dr., Karl-Krekeler-Strasse 5, D-5090 Leverkusen (DE)**
Erfinder: **Schroeder, Bernd, Dr., Schulstrasse 8, D-2226 Eddelak (DE)**

EP 0 032 373 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Lichtsammelsysteme und die Verwendung von Anthrapyrimidinderivaten als Energiewandler in ihnen

Vorrichtungen zum Sammeln diffuser elektromagnetischer Strahlung durch Ausnützen der Fluoreszenz sind bekannt. Kernstück der Sammler ist ein gegenüber der Umgebung optisch dichteres Medium, das fluoreszenzfähige Zentren enthält (DE-A 2 620 115).

Die ökonomische Verwendbarkeit eines Lichtsammelsystems wird in hohem Maße von der Brauchbarkeit des in ihm als Lichtwandler eingesetzten Farbstoffs bestimmt. An die optische Qualität dieses Farbstoffs werden extreme Anforderungen gestellt [Appl. Phys. 14 123 – 139 (1977)].

Die Erfindung betrifft neue Lichtsammelsysteme, die dadurch gekennzeichnet sind, daß sie als Energiewandler ein Anthrapyrimidinderivat der Formel

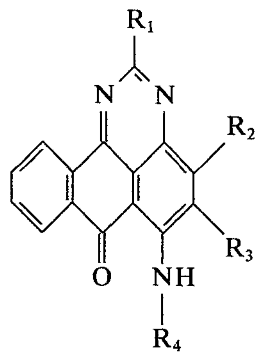

(I)

in der

$R_1$ Wasserstoff, Alkyl, Cycloalkyl, Aryl, Aralkyl, $-NHR_5$ oder $-OR_6$ bedeuten, wobei $R_5$, $R_6$ für Wasserstoff, Alkyl, Cycloalkyl, Aryl oder Aralkyl stehen und die für $R_1$, $R_5$ sowie $R_6$ genannten Kohlenwasserstoffreste substituiert sein können;

$R_2$, $R_3$ Wasserstoff, Cyan oder $-OR_7$ bezeichnen, wobei $R_7$ für Alkyl, Cycloalkyl, Aryl oder Aralkyl steht, wobei die Kohlenwasserstoffreste $R_7$ substituiert sein können und

$R_4$ Wasserstoff, Alkyl, Cycloalkyl, Aralkyl oder Aryl bezeichnet, wobei die Kohlenwasserstoffreste $R_4$ substituiert sein können.

Alkyl ($R_1$, $R_4$, $R_5$, $R_6$, $R_7$) steht bevorzugt für $C_1-C_6$-Alkyl.

Cycloalkyl ($R_1$, $R_4$, $R_5$, $R_6$, $R_7$) steht bevorzugt für $C_3-C_7$-Cycloalkyl, besonders bevorzugt für Cyclopentyl und Cyclohexyl.

Aryl ($R_1$, $R_4$, $R_5$, $R_6$, $R_7$) steht bevorzugt für Phenyl. Aralkyl ($R_1$, $R_4$, $R_5$, $R_6$, $R_7$) steht bevorzugt für Benzyl oder Phenethyl.

Die vorstehend genannten Kohlenwasserstoffreste können auch substituiert sein.

Bevorzugt werden Verbindungen der Formel

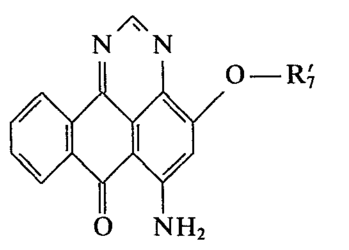

(III)

als Energiewandler in Lichtsammelsystemen verwendet.

In Formel (II) steht $R'_7$ für einen Phenylrest, der durch Halogen insbesondere Chlor und Brom $C_1-C_4$-Alkyl, $C_1-C_4$-Alkoxy, gegebenenfalls durch $C_1-C_4$-Alkyl mono- oder disubstituiertes Sulfamoyl oder Phenyl- oder $C_1-C_4$-Alkyl-sulfonylamino, substituiert sein kann.

Besonders bevorzugte Verwendung findet

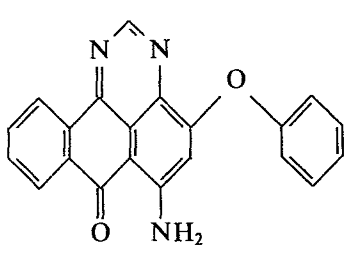

Die erfindungsgemäß als Energiewandler in Lichtsammelsystemen verwendbaren Verbindungen sind bekannt [s. z. B. DE-B 1 258 000; DE-C 683 317, R. W. Jones, I. K. Landquist, W. Senior, Brit. J. Pharmacol. 7 486 (1952)] oder können in Analogie zu literaturbekannten Verfahren hergestellt werden.

Die neuen Lichtsammelsysteme, bei denen es sich um Formkörper geeigneter Geometrie, d. h. optische Systeme handelt, bei denen das Verhältnis von Emissions- zu Absorptionsfläche 1 : 50 bis 1 : 2000 betragen kann, sind geeignet, einfallende diffuse elektromagnetische Strahlung zu absorbieren und sie in einem gegenüber der Umgebung optisch dichterem Medium nahezu verlustlos zu emittieren, wodurch der Hauptteil des Emissionslichtes total reflektiert im Medium verbleibt.

Nur der Anteil des emittierten Lichts, dessen Emissionsbande weitgehend frei von Absorption ist, ist für den erfindungsgemäßen Zweck nutzbar.

Daher ist es zweckmäßig, die Farbstoffe der Formel (I) vor Einsatz in die Lichtsammelsysteme besonders zu reinigen. Insbesondere müssen sie weitgehend frei sein von langwellig absorbierenden Verunreinigungen.

Die Erfindung betrifft demnach bevorzugt Lichtsammelsysteme, die dadurch gekennzeichnet sind, daß sie einen Farbstoff der Formel (I) enthalten, der in einer 0,05%igen Lösung, beispielsweise in Chloroform, gemessen in einer Schichtdicke von 10 cm, einen Anstieg der Transmission von 0% auf >90% bei einer Änderung der Wellenlänge von 25—100 nm, vorzugsweise 25—45 nm aufweist.

Die Reinigung der Farbstoffe kann in günstigen Fällen durch mehrfache sorgfältige Kristallisation erfolgen. Zumeist ist eine säulenchromatographische Trennung an festen Träger wie $Al_2O_3$ oder $SiO_2$ erforderlich. Besonders schonend erhält man hohe Reinheitsgrade verteilungschromatographisch, z. B. durch Steady-State oder Gegenstromverteilung nach Craig.

Die neuen Lichtsammelsysteme können z. B. in Verbindung mit Solarzellen zur Nutzbarmachung der Sonnenenergie und in Szintillatoren bekannter Art [s. z. B. J. B. Birks: The Theory and Practice of Scintillation Counting (Pergamon Press, London 1964), J. Opt. Am. 39, 912 (1949), J. Appl. Phys. 40, 3544 (1969); Nuclear Instruments a. Methods 87, 111—123 (1970); Research Disclosure, S. 43 (1977); DE-OS 2 629 641] Verwendung finden. Darüber hinaus eignen sie sich in Verbindung mit elektronischen Steuerungen als Anzeigevorrichtungen mit sehr geringem Energieverbrauch, und weiterhin eignen sie sich ohne elektronische Bauteile für vielerlei Anzeige-, Hinweis- und Markierungszwecke, z. B. in passiven Anzeigeelementen, Hinweis- und Verkehrszeichen wie Ampeln.

Die erfindungsgemäßen Lichtsammelsysteme enthalten den Farbstoff in einer Flüssigkeit oder einem Festkörper gelöst, wobei je nach Einsatzgebiet des Lichtsammelsystems, verschiedenste geometrische Formen in Frage kommen. Geeignete feste Medien wie sie z. B. zum Sammeln von Licht in Verbindung mit Solarzellen und in passiven Anzeigeelementen eingesetzt werden sind z. B. lichtdurchlässige, optisch verwendbare Kunststoffe wie Homo- und Copolymerisate der Acrylsäure(derivate) oder Polycarbonate. Des weiteren können die Lichtsammelsysteme den Farbstoff auch in einer Flüssigkeit — z. B. Alkohol, Keton, Halogenkohlenwasserstoff, Ether — gelöst enthalten. Gut geeignete Lösungsmittel sind z. B. Ethanol, Propanol, Methyl-ethyl-keton, Aceton, Cyclohexanon, Chloroform, Perchlorethylen, Glykolmonomethylether.

Die Verwendung der Farbstoffe der Formel (I) in Feststoffen ist bevorzugt.

Die erfindungsgemäße Verwendung der Farbstoffe der Formel (I) ist in hohem Maße vorteilhaft, da sie neben einer guten Quantenausbeute und einem hohen Verstärkungsfaktor ausgezeichnete Lichtechtheit aufweisen und damit eine ökonomische Verwendbarkeit der neuen Lichtsammelsysteme gewährleisten.

Es muß als überraschend bezeichnet werden, daß die Farbstoffe der Formel (I) sich zur vorteilhaften Verwendung in Lichtsammelsystemen eignen, da zahlreiche stark fluoreszierende Farbstoffe wie z. B. Rhodamin G nicht brauchbar sind. Ebenso sind die schon sehr weitgehenden Forderungen, die an die optische Qualität von Laserfarbstoffen gestellt werden, in vielen Fällen nicht ausreichend, um die Verwendung dieser Farbstoffe in Lichtsammelsystemen zu empfehlen.

## Beispiel 1

17 g 4-Phenoxy-6-amino-anthrapyrimidin werden in 750 ml Xylol unter Zusatz von Tonsil kristallisiert. Man erhält 15 g eines dunkel gefärbten Produkts, das in 750 ml $CHCl_3$ gelöst und mit 200 g $Al_2O_3$ (Aktivität II) versetzt, zur Trockene eingedampft wird. Dieses Pulver wird mit 1 kg $Al_2O_3$ Akt. II in einer Chromatographiesäule unterschichtet und das aufgezogene Produkt mit einer Mischung $CH_2Cl_2$ : Toluol (2 : 1) (V/V) eluiert. Man erhält 2 g eines hellgelben Vorlaufs, der analysenreines Produkt enthält, sowie 6,5 g einer gelb gefärbten Hauptfraktion. Diese beiden Fraktionen werden gemeinsam zunächst aus Chlorbenzol/Tonsil, dann aus reinem Chlorbenzol kristallisiert.

Der Nachlauf der Säule liefert nochmals 3,7 g einer weniger reinen Fraktion, die überwiegend aus der Zielverbindung besteht.

503,8 mg der Verbindung werden in 1 Liter $CHCl_3$ gelöst und in einer Schichtdicke von 10 cm die Transmission T gemessen. Die Durchlässigkeit beträgt 0% bei 450 nm und 95% bei 480 nm. Die Fluoreszenzquantenausbeute $\Phi$ beträgt 0,77, der Stokes-Shift ($\Delta$) 72 nm und der Anteil der nutzbaren Fluoreszenz 71%.

Mit den in Tabelle I angegebenen Verbindungen verfährt man analog zu Beispiel 1 und erhält die folgenden Werte:

| Beispiel | $R_1$ | $R_2$ | $R_3$ | $R_4$ | $\Phi$ | nutzb. Fl. | $\Delta$ Stokes |
|---|---|---|---|---|---|---|---|
| 2 | $NH_2$ | H | H | $CH_3$ | 0,79 | 69 | 19 |
| 3 | OH | H | H | H | 0,45 | 58 | 14 |
| 4 | 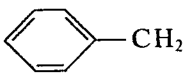 | H | H | H | 0,43 | 51 | 10 |
| 5 | 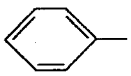 | H | H | H | 0,57 | 52 | 14 |
| 6 | 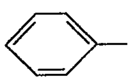 | 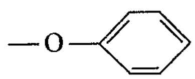 | 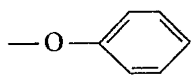 | H | 0,62 | 54 | 9 |
| 7 | H | CN | CN | H | 0,54 | 55 | 11 |

Zur Herstellung fester Lichtsammelsysteme werden die Verbindungen der Beispiele 1–6 zu 0,1 Gew.-% in handelsübliches Polyacrylat, Polymethacrylat oder Polycarbonat eingearbeitet, der gefärbte Kunststoff granuliert und zu Platten geeigneter Geometrie gepreßt.

**Patentansprüche**

1. Lichtsammelsystem, dadurch gekennzeichnet, daß es ein Anthrapyrimidinderivat der Formel

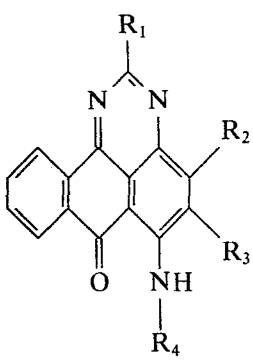

enthält, in der

$R_1$ Wasserstoff, Alkyl, Cycloalkyl, Aryl, Aralkyl, $-NHR_5$ oder $-OR_6$ bedeuten, wobei
$R_5$, $R_6$ für Wasserstoff, Alkyl, Cycloalkyl, Aryl oder Aralkyl stehen und die für $R_1$, $R_5$ sowie $R_6$ genannten Kohlenwasserstoffreste substituiert sein können;
$R_2$, $R_3$ Wasserstoff, Cyan oder $-OR_7$ bezeichnen, wobei $R_7$ für Alkyl, Cycloalkyl, Aryl oder Aralkyl steht, wobei die Kohlenwasserstoffreste $R_7$ substituiert sein können und
$R_4$ Wasserstoff, Alkyl, Cycloalkyl, Aralkyl oder Aryl bezeichnet, wobei die Kohlenwasserstoffreste $R_4$ substituiert sein können.

2. Lichtsammelsystem gemäß Anspruch 1, dadurch gekennzeichnet, daß Alkyl ($R_1$, $R_4$, $R_5$, $R_6$, $R_7$) für $C_1-C_6$-Alkyl, Cycloalkyl ($R_1$, $R_4$, $R_5$, $R_6$, $R_7$) für $C_3-C_7$-Cycloalkyl, bevorzugt für Cyclopentyl und Cyclohexyl, Aryl ($R_1$, $R_4$, $R_5$, $R_6$, $R_7$) für Phenyl, Aralkyl ($R_1$, $R_4$, $R_5$, $R_6$, $R_7$) für Benzyl oder Phenethyl steht, wobei die genannten Kohlenwasserstoffreste substituiert sein können.

3. Lichtsammelsystem, dadurch gekennzeichnet, daß es eine Verbindung der Formel

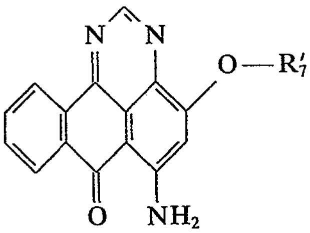

enthält in der $R'_7$ für einen Phenylrest, der durch Halogen insbesondere Chlor und Brom, $C_1-C_4$-Alkyl, $C_1-C_4$-Alkoxy, gegebenenfalls durch $C_1-C_4$-Alkyl mono- oder disubstituiertes Sulfamoyl oder Phenyl- oder $C_1-C_4$-Alkylsulfonylamino, substituiert sein kann, steht.

4. Lichtsammelsystem, dadurch gekennzeichnet, daß es die Verbindung

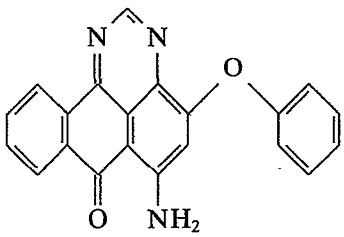

enthält.

5. Lichtsammelsystem, dadurch gekennzeichnet, daß es eine Verbindung gemäß den Ansprüchen 1–4 enthält, die in einer 0,05%igen Lösung, gemessen in einer Schichtdicke vom 10 cm, einen Anstieg der Transmission von 0% auf >90% bei einer Änderung der Wellenlänge von 25–100 nm, vorzugsweise 25–45 nm aufweist.

6. Verwendung von Anthrapyrimidinderivaten gemäß den Ansprüchen 1–6 als Energiewandler in Lichtsammelsystemen.

**Claims**

1. Light-collecting system, characterised in that it contains an anthrapyrimidine derivative of the formula

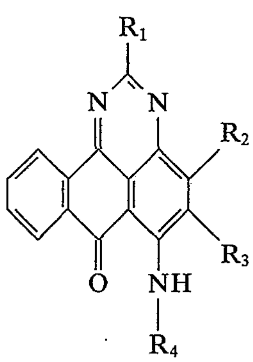

in which

$R_1$ denotes hydrogen, alkyl, cycloalkyl, aryl, aralkyl, $-NHR_5$ or $-OR_6$,

wherein

$R_5$ and $R_6$ represent hydrogen, alkyl, cycloalkyl, aryl or aralkyl and the hydrocarbon radicals mentioned for $R_1$, $R_5$ and $R_6$ can be substituted;

$R_2$ and $R_3$ designate hydrogen, cyano or $-OR_7$,

wherein

$R_7$ represents alkyl, cycloalkyl, aryl or aralkyl, it being possible for the hydrocarbon radicals $R_7$ to be substituted, and

$R_4$ designates hydrogen, alkyl, cycloalkyl, aralkyl or aryl, it being possible for the hydrocarbon radicals $R_4$ to be substituted.

2. Light-collecting system according to Claim 1, characterised in that alkyl ($R_1$, $R_4$, $R_5$, $R_6$, $R_7$) represents $C_1-C_6$-alkyl, cycloalkyl ($R_1$, $R_4$, $R_5$, $R_6$, $R_7$) represents $C_3-C_7$-cycloalkyl, preferably cyclopentyl or cyclohexyl, aryl ($R_1$, $R_4$, $R_5$, $R_6$, $R_7$) represents phenyl and aralkyl ($R_1$, $R_4$, $R_5$, $R_6$, $R_7$) represents benzyl or phenethyl, it being possible for the hydrocarbon radicals mentioned to be substituted.

3. Light-collection system, characterised in that it contains a compound of the formula

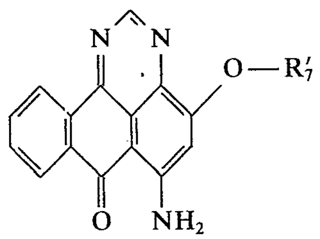

in which

$R'_7$ represents a phenyl radical, which can be substituted by halogen, in particular chlorine or bromine, $C_1-C_4$-alkyl, $C_1-C_4$-alkoxy, sulphamoyl which is optionally monosubstituted or disubstituted by $C_1-C_4$-alkyl, or phenyl- or $C_1-C_4$-alkylsulphonylamino.

4. Light-collecting system, characterised in that it contains the compound

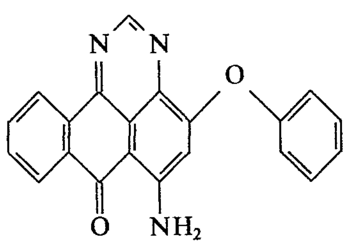

5. Light-collecting system, characterised in that it contains a compound according to Claims 1—4, which, in a 0.05% strength solution exhibits a rise in transmission from 0% to >90% for a change of wavelength of 25—100 nm, preferably 25—45 nm, measured with a cell thickness of 10 cm.

6. Use of anthrapyrimidine derivatives according to Claims 1—6 as energy converters in light-collecting systems.

**Revendications**

1. Système collecteur de lumière, caractérisé en ce qu'il comporte un dérivé anthrapyrimidique de formule:

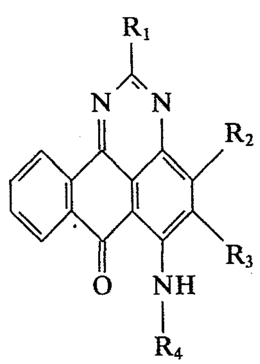

dans laquelle

$R_1$ est l'hydrogène ou un groupe alkyle, cycloalkyle, aryle, aralkyle, $-NHR_5$ ou $-OR_6$, où

$R_5$, $R_6$ désignent l'hydrogène, un groupe alkyle, cycloalkyle, aryle ou aralkyle et les restes

hydrocarbonés mentionnés pour $R_1$, $R_5$ ainsi que $R_6$ peuvent être substitués,

$R_2$, $R_3$ représentent l'hydrogène, un groupe cyano ou un groupe $-OR_7$, où $R_7$ est un radical alkyle, cycloalkyle, aryle ou aralkyle, les restes hydrocarbonés $R_7$ pouvant être substitués, et

$R_4$ est l'hydrogène ou un groupe alkyle, cycloalkyle, aralkyle ou aryle, les restes hydrocarbonés $R_4$ pouvant être substitués.

2. Système collecteur de lumière suivant la revendication 1, caractérisé en ce que le groupe alkyle ($R_1$, $R_4$, $R_5$, $R_6$, $R_7$) est un groupe alkyle en $C_1$ à $C_6$, le groupe cycloalkyle, ($R_1$, $R_4$, $R_5$, $R_6$, $R_7$) est un groupe cycloalkyle en $C_3$ à $C_7$, de préférence cyclopentyle et cyclohexyle, le groupe aryle ($R_1$, $R_4$, $R_5$, $R_6$, $R_7$) est un groupe phényle, le groupe aralkyle ($R_1$, $R_4$, $R_5$, $R_6$, $R_7$) est un groupe benzyle ou phénétyle, les restes hydrocarbonés mentionnés pouvant être substitués.

3. Système collecteur de lumière, caractérisé en ce qu'il comporte un composé de formule:

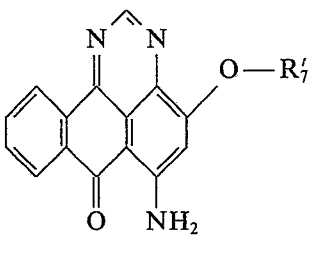

dans laquelle

$R'_7$ est un reste phényle qui peut être substitué par un halogène, notamment le chlore et le brome, un groupe alkyle en $C_1$ à $C_4$, alkoxy en $C_1$ à $C_4$, sulfamoyle éventuellement mono- ou disubstitué par un radical alkyle en $C_1$ à $C_4$ ou phényl- ou (alkyle en $C_1$ à $C_4$)-sulfonylamino.

4. Système collecteur de lumière, caractérisé en ce qu'il contient le composé de formule:

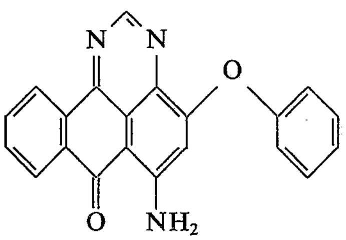

5. Système collecteur de lumière, caractérisé en ce qu'il contient un composé suivant les revendications 1à 4, qui présente en solution à 0,05%, mesurée sur une épaisseur de couche de 10 cm, une montée de la transmission de 0% à plus de 90% pour une variation de longueur d'onde de 25 à 100 nm, de préférence de 25 à 45 nm.

6. Utilisation de dérivés anthrapyrimidiques suivant les revendications 1à 6 comme transformateurs d'énergie dans des systèmes collecteurs de lumière.